(19) Europäisches Patentamt
European Patent Office
Office européen des brevets

(11) **EP 4 156 691 A2**

(12) **EUROPEAN PATENT APPLICATION**

(43) Date of publication:
**29.03.2023 Bulletin 2023/13**

(21) Application number: **22196022.2**

(22) Date of filing: **16.09.2022**

(51) International Patent Classification (IPC):
**H04N 19/895** (2014.01)     **H04N 19/65** (2014.01)
**H03M 13/00** (2006.01)

(52) Cooperative Patent Classification (CPC):
**H04N 19/895; H03M 13/00; H04N 19/65**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.09.2021 FI 20216002**

(71) Applicant: **Nokia Technologies Oy
02610 Espoo (FI)**

(72) Inventors:
• **ZHANG, Honglei
  Tampere (FI)**
• **CRICRÌ, Francesco
  Tampere (FI)**
• **LAINEMA, Jani
  Tampere (FI)**
• **REZAZADEGAN TAVAKOLI, Hamed
  Espoo (FI)**
• **MALAMAL VADAKITAL, Vinod Kumar
  Tampere (FI)**

(74) Representative: **Nokia EPO representatives
Nokia Technologies Oy
Karakaari 7
02610 Espoo (FI)**

(54) **A METHOD, AN APPARATUS AND A COMPUTER PROGRAM PRODUCT FOR VIDEO ENCODING AND VIDEO DECODING**

(57) The embodiments relate to a method comprising processing data in a neural network -based coding system comprising at least one floating-point neural network; and adapting the neural network - based coding system to be numerical stable by using one or more of the following: adding an error detection code to an output generated in the neural network -based coding system; tweaking a latent representation generated in the neural network -based coding system; using adjustment parameters to adjust outputs generated in the neural network -based coding system; training neural networks with loss terms to avoid output values close to a decision boundary; using mixed data types in certain operations. The embodiments also concern to an apparatus for implementing the method.

Fig. 4

**Description**

Technical Field

The present solution generally relates to neural network-based video coding system.

Background

One of the elements in image and video compression is to compress data while maintaining the quality to satisfy human perceptual ability. However, in recent development of machine learning, machines can replace humans when analyzing data for example in order to detect events and/or objects in video/image. Thus, when decoded image data is consumed by machines, the quality of the compression can be different from the human approved quality. Therefore a concept Video Coding for Machines (VCM) has been provided.

Summary

The scope of protection sought for various embodiments of the invention is set out by the independent claims. The embodiments and features, if any, described in this specification that do not fall under the scope of the independent claims are to be interpreted as examples useful for understanding various embodiments of the invention.

Various aspects include a method, an apparatus and a computer readable medium comprising a computer program stored therein, which are characterized by what is stated in the independent claims. Various embodiments are disclosed in the dependent claims.

According to a first aspect, there is provided an apparatus comprising means for processing data in a neural network -based coding system comprising at least one floating-point neural network; and means for adapting the neural network-based coding system to be numerical stable by using one or more of the following:

- adding an error detection code to an output generated in the neural network -based coding system;
- tweaking a latent representation generated in the neural network - based coding system;
- using adjustment parameters to adjust outputs generated in the neural network -based coding system;
- training neural networks with loss terms to avoid output values close to a decision boundary; and
- using floating-point data for training and using mixed data types for encoding and decoding.

According to a second aspect, there is provided a method comprising processing data in a neural network -based coding system comprising at least one floating-point neural network; and adapting the neural network -based coding system to be numerical stable by using one or more of the following:

- adding an error detection code to an output generated in the neural network -based coding system;
- tweaking a latent representation generated in the neural network - based coding system;
- using adjustment parameters to adjust outputs generated in the neural network -based coding system;
- training neural networks with loss terms to avoid output values close to a decision boundary; and
- using floating-point data for training and using mixed data types for encoding and decoding.

According to a third aspect, there is provided an apparatus comprising at least one processor, memory including computer program code, the memory and the computer program code configured to, with the at least one processor, cause the apparatus to perform at least the following: process data in a neural network -based coding system comprising at least one floating-point neural network; and adapt the neural network -based coding system to be numerical stable by using one or more of the following:

- adding an error detection code to an output generated in the neural network -based coding system;
- tweaking a latent representation generated in the neural network - based coding system;
- using adjustment parameters to adjust outputs generated in the neural network -based coding system;
- training neural networks with loss terms to avoid output values close to a decision boundary; and
- using floating-point data for training and using mixed data types for encoding and decoding.

According to a fourth aspect, there is provided a computer program product comprising computer program code configured to, when executed on at least one processor, cause an apparatus or a system to: process data in a neural network - based coding system comprising at least one floating-point neural network; and adapt the neural network -based coding system to be numerical stable by using one or more of the following:

- adding an error detection code to an output generated in the neural network -based coding system;
- tweaking a latent representation generated in the neural network - based coding system;
- using adjustment parameters to adjust outputs generated in the neural network -based coding system;
- training neural networks with loss terms to avoid output values close to a decision boundary; and
- using floating-point data for training and using mixed data types for encoding and decoding.

According to an embodiment, the neural network -based coding system comprises means for encoding input data comprising data points into a compressed representation; means for estimating probability distribution of all possible values for a data point; means for encoding the data points to a bitstream using the estimated probability distributions; and means for decoding the data points from the bitstream to recover the compressed representation.

According to an embodiment, the neural network -based coding system comprises means for determining an ambiguous interval as a range of values around a precise output value being a decision boundary; and means for determining when a data point falls into an ambiguous interval, and means for defining two possible output values for such data point.

According to an embodiment, an error detection code is derived based on all possible output values; the correct output values are determined among all the possibilities by means of the error detection code; and sending the error detection codes are sent from an encoder to a decoder in compressed or uncompressed format.

According to an embodiment, the means for deriving the error detection code comprises means for generating a parity sequence for each output value of all possible output values; means for determining a checksum of each parity sequence; means for converting the checksums into a binary format; means for determining minimum length of bits distinguishing a correct output value from all output values and generating an identity code based on the distinguishing bits; and means for generating an error detection code by concatenating the length of identity code and the identity code together.

According to an embodiment the means for training the apparatus with floating-point data type and for encoding and decoding data with mixed data type in operations relating to encoding and/or decoding, comprises means for determining one or more scaling factors based on a predefined significant precision bits; means for scaling the floating-point data used for mathematical operations by the one or more scaling factors; means for converting the scaled data into integer data type; means for applying the mathematical operation to the converted data; means for converting the output of the mathematical operations into floating-point data type; and means for applying the one or more scaling factors to the output of the mathematical operations.

According to an embodiment, means for determining one or more scaling factors, comprises means for transferring the number of significant bits from the encoder to the decoder; means for determining the one or more scaling factors at the encoder and transferring the one or more scaling factors to the decoder; and means for determining different scaling factors for the components in the neural network-based coding system,

According to an embodiment, the computer program product is embodied on a non-transitory computer readable medium.

Description of the Drawings

In the following, various embodiments will be described in more detail with reference to the appended drawings, in which

Fig. 1    shows an example of a codec with neural network (NN) components;

Fig. 2    shows another example of a video coding system with neural network components;

Fig. 3    shows an example of a neural auto-encoder architecture;

Fig. 4    shows an example of a neural network-based end-to-end learned video coding system;

Fig. 5    shows an example of encoder ambiguous interval and decoder ambiguous interval;

Fig. 6    is a flowchart illustrating a method according to an embodiment; and

Fig. 7    shows an apparatus according to an embodiment.

Description of Example Embodiments

The following description and drawings are illustrative and are not to be construed as unnecessarily limiting. The specific details are provided for a thorough understanding of the disclosure. However, in certain instances, well-known or conventional details are not described in order to avoid obscuring the description. References to one or an embodiment in the present disclosure can be, but not necessarily are, reference to the same embodiment and such references mean at least one of the embodiments.

Reference in this specification to "one embodiment" or "an embodiment" means that a particular feature, structure, or characteristic described in connection with the embodiment is included in at least one embodiment of the disclosure.

A neural network (NN) is a computation graph consisting of several layers of computation. Each layer consists of one or more units, where each unit performs an elementary computation. A unit is connected to one or more other units, and the connection may have associated with a weight. The weight may be used for scaling the signal passing through the associated connection. Weights are learnable parameters, i.e., values which can be learned from training data. There may be other learnable parameters, such as those of batch-normalization layers.

Two of the most widely used architectures for neural networks are feed-forward and recurrent architectures. Feed-forward neural networks are such that there is no feedback loop: each layer takes input from one or more of the layers before and provides its output as the input for one or more of the subsequent layers. Also, units inside a certain layer take input from units in one or more of preceding layers, and provide output to one or more of following layers.

Initial layers (those close to the input data) extract semantically low-level features such as edges and textures in images, and intermediate and final layers extract more high-level features. After the feature extraction layers there may be one or more layers performing a certain task, such as classification, semantic segmentation, object detection, denoising, style transfer, super-resolution, etc. In recurrent neural nets, there is a feedback loop, so that the network becomes stateful, i.e., it is able to memorize information or a state.

Neural networks are being utilized in an ever-increasing number of applications for many different types of device, such as mobile phones. Examples include image and video analysis and processing, social media data analysis, device usage data analysis, etc.

One of the important properties of neural networks (and other machine learning tools) is that they are able to learn properties from input data, either in supervised way or in unsupervised way. Such learning is a result of a training algorithm, or of a meta-level neural network providing the training signal.

In general, the training algorithm consists of changing some properties of the neural network so that its output is as close as possible to a desired output. For example, in the case of classification of objects in images, the output of the neural network can be used to derive a class or category index which indicates the class or category that the object in the input image belongs to. Training usually happens by minimizing or decreasing the output's error, also referred to as the loss. Examples of losses are mean squared error, cross-entropy, etc. In recent deep learning techniques, training is an iterative process, where at each iteration the algorithm modifies the weights of the neural net to make a gradual improvement of the network's output, i.e., to gradually decrease the loss.

In this description, terms "model" and "neural network" are used interchangeably, and also the weights of neural networks are sometimes referred to as learnable parameters or simply as parameters.

Training a neural network is an optimization process, but the final goal is different from the typical goal of optimization. In optimization, the only goal is to minimize a function. In machine learning, the goal of the optimization or training process is to make the model learn the properties of the data distribution from a limited training dataset. In other words, the goal is to learn to use a limited training dataset in order to learn to generalize to previously unseen data, i.e., data which was not used for training the model. This is usually referred to as generalization. In practice, data may be split into at least two sets, the training set and the validation set. The training set is used for training the network, i.e., to modify its learnable parameters in order to minimize the loss. The validation set is used for checking the performance of the network on data which was not used to minimize the loss, as an indication of the final performance of the model. In particular, the errors on the training set and on the validation set are monitored during the training process to understand the following things:

- If the network is learning at all - in this case, the training set error should decrease, otherwise the model is in the regime of underfitting.
- If the network is learning to generalize - in this case, also the validation set error needs to decrease and to be not too much higher than the training set error. If the training set error is low, but the validation set error is much higher than the training set error, or it does not decrease, or it even increases, the model is in the regime of overfitting. This means that the model has just memorized the training set's properties and performs well only on that set, but performs poorly on a set not used for tuning its parameters.

Lately, neural networks have been used for compressing and de-compressing data such as images, i.e., in an image codec. The most widely used architecture for realizing one component of an image codec is the auto-encoder, which is a neural network consisting of two parts: a neural encoder and a neural decoder. The neural encoder takes as input an image and produces a code which requires less bits than the input image. This code may be obtained by applying a binarization or quantization process to the output of the encoder. The neural decoder takes in this code and reconstructs the image which was input to the neural encoder.

Such neural encoder and neural decoder may be trained to minimize a combination of bitrate and distortion, where the distortion may be based on one or more of the following metrics: Mean Squared Error (MSE), Peak Signal-to-Noise Ratio (PSNR), Structural Similarity Index Measure (SSIM), or similar. These distortion metrics are meant to be correlated to the human visual perception quality, so that minimizing or maximizing one or more of these distortion metrics results into improving the visual quality of the decoded image as perceived by humans.

Video codec comprises an encoder that transforms the input video into a compressed representation suited for storage/transmission and a decoder that can decompress the compressed video representation back into a viewable form. An encoder may discard some information in the original video sequence in order to represent the video in a more compact form (that is, at lower bitrate).

Hybrid video codecs, for example ITU-T H.263 and H.264, may encode the video information in two phases. Firstly pixel values in a certain picture area (or "block") are predicted for example by motion compensation means (finding and indicating an area in one of the previously coded video frames that corresponds closely to the block being coded) or by spatial means (using the pixel values around the block to be coded in a specified manner). Secondly the prediction error, i.e. the difference between the predicted block of pixels and the original block of pixels, is coded. This may be done by transforming the difference in pixel values using a specified transform (e.g. Discrete Cosine Transform (DCT) or a variant of it), quantizing the coefficients and entropy coding the quantized coefficients. By varying the fidelity of the quantization process, encoder can control the balance between the accuracy of the pixel representation (picture quality) and size of the resulting coded video representation (file size or transmission bitrate).

Inter prediction, which may also be referred to as temporal prediction, motion compensation, or motion-compensated prediction, exploits temporal redundancy. In inter prediction the sources of prediction are previously decoded pictures.

Intra prediction utilizes the fact that adjacent pixels within the same picture are likely to be correlated. Intra prediction can be performed in spatial or transform domain, i.e., either sample values or transform coefficients can be predicted. Intra prediction is typically exploited in intra coding, where no inter prediction is applied.

One outcome of the coding procedure is a set of coding parameters, such as motion vectors and quantized transform coefficients. Many parameters can be entropy-coded more efficiently if they are predicted first from spatially or temporally neighboring parameters. For example, a motion vector may be predicted from spatially adjacent motion vectors and only the difference relative to the motion vector predictor may be coded. Prediction of coding parameters and intra prediction may be collectively referred to as in-picture prediction.

The decoder reconstructs the output video by applying prediction means similar to the encoder to form a predicted representation of the pixel blocks (using the motion or spatial information created by the encoder and stored in the compressed representation) and prediction error decoding (inverse operation of the prediction error coding recovering the quantized prediction error signal in spatial pixel domain). After applying prediction and prediction error decoding means, the decoder sums up the prediction and prediction error signals (pixel values) to form the output video frame. The decoder (and encoder) can also apply additional filtering means to improve the quality of the output video before passing it for display and/or storing it as prediction reference for the forthcoming frames in the video sequence.

In video codecs, the motion information may be indicated with motion vectors associated with each motion compensated image block. Each of these motion vectors represents the displacement of the image block in the picture to be coded (in the encoder side) or decoded (in the decoder side) and the prediction source block in one of the previously coded or decoded pictures. In order to represent motion vectors efficiently, those may be coded differentially with respect to block specific predicted motion vectors. In video codecs, the predicted motion vectors may be created in a predefined way, for example calculating the median of the encoded or decoded motion vectors of the adjacent blocks. Another way to create motion vector predictions is to generate a list of candidate predictions from adjacent blocks and/or co-located blocks in temporal reference pictures and signaling the chosen candidate as the motion vector predictor. In addition to predicting the motion vector values, the reference index of previously coded/decoded picture can be predicted. The reference index is typically predicted from adjacent blocks and/or or co-located blocks in temporal reference picture. Moreover, high efficiency video codecs can employ an additional motion information coding/decoding mechanism, often called merging/merge mode, where all the motion field information, which includes motion vector and corresponding reference picture index for each available reference picture list, is predicted and used without any modification/correction. Similarly, predicting the motion field information may be carried out using the motion field information of adjacent blocks and/or co-located blocks in temporal reference pictures and the used motion field information is signaled among a list of motion field candidate list filled with motion field information of available adjacent/co-located blocks.

In video codecs the prediction residual after motion compensation may be first transformed with a transform kernel (like DCT) and then coded. The reason for this is that often there still exists some correlation among the residual and transform can in many cases help reduce this correlation and provide more efficient coding.

Video encoders may utilize Lagrangian cost functions to find optimal coding modes, e.g. the desired Macroblock mode and associated motion vectors. This kind of cost function uses a weighting factor $\lambda$ to tie together the (exact or estimated) image distortion due to lossy coding methods and the (exact or estimated) amount of information that is required to represent the pixel values in an image area:

$$C = D + \lambda R$$

where C is the Lagrangian cost to be minimized, D is the image distortion (e.g. Mean Squared Error) with the mode and motion vectors considered, and R the number of bits needed to represent the required data to reconstruct the image block in the decoder (including the amount of data to represent the candidate motion vectors).

Video coding specifications may enable the use of supplemental enhancement information (SEI) messages or alike. Some video coding specifications include SEI NAL units, and some video coding specifications contain both prefix SEI NAL units and suffix SEI NAL units, where the former type can start a picture unit or alike and the latter type can end a picture unit or alike. An SEI NAL unit contains one or more SEI messages, which are not required for the decoding of output pictures but may assist in related processes, such as picture output timing, post-processing of decoded pictures, rendering, error detection, error concealment, and resource reservation. Several SEI messages are specified in H.264/AVC, H.265/HEVC, H.266/VVC, and H.274/VSEI standards, and the user data SEI messages enable organizations and companies to specify SEI messages for their own use. The standards may contain the syntax and semantics for the specified SEI messages but a process for handling the messages in the recipient might not be defined. Consequently, encoders may be required to follow the standard specifying a SEI message when they create SEI message(s), and decoders might not be required to process SEI messages for output order conformance. One of the reasons to include the syntax and semantics of SEI messages in standards is to allow different system specifications to interpret the supplemental information identically and hence interoperate. It is intended that system specifications can require the use of particular SEI messages both in the encoding end and in the decoding end, and additionally the process for handling particular SEI messages in the recipient can be specified.

Image and video codecs may use a set of filters to enhance the visual quality of the predicted visual content and can be applied either in-loop or out-of-loop, or both. In the case of in-loop filters, the filter applied on one block in the currently-encoded frame will affect the encoding of another block in the same frame and/or in another frame which is predicted from the current frame. An in-loop filter can affect the bitrate and/or the visual quality. In fact, an enhanced block will cause a smaller residual (difference between original block and predicted-and-filtered block), thus requiring less bits to be encoded. An out-of-the loop filter will be applied on a frame after it has been reconstructed, the filtered visual content won't be as a source for prediction, and thus it may only impact the visual quality of the frames that are output by the decoder.

Recently, neural networks (NNs) have been used in the context of image and video compression, by following mainly two approaches.

In one approach, NNs are used to replace one or more of the components of a traditional codec such as WC/H.266. Here, term "traditional" refers to those codecs whose components and their parameters may not be learned from data. Examples of such components are:

- Additional in-loop filter, for example by having the NN as an additional in-loop filter with respect to the traditional loop filters.
- Single in-loop filter, for example by having the NN replacing all traditional in-loop filters.
- Intra-frame prediction.
- Inter-frame prediction.
- Transform and/or inverse transform.
- Probability model for the arithmetic codec.
- Etc.

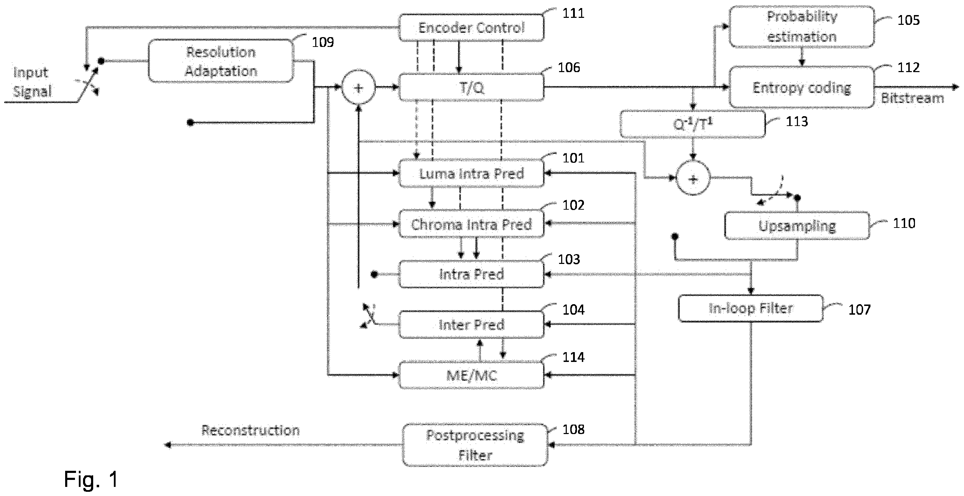

Figure 1 illustrates examples of functioning of NNs as components of a traditional codec's pipeline, in accordance with an embodiment. In particular, Figure 1 illustrates an encoder, which also includes a decoding loop. Figure 1 is shown to include components described below:

- A luma intra pred block or circuit 101. This block or circuit performs intra prediction in the luma domain, for example, by using already reconstructed data from the same frame. The operation of the luma intra pred block or circuit 101 may be performed by a deep neural network such as a convolutional auto-encoder.

- A chroma intra pred block or circuit 102. This block or circuit performs intra prediction in the chroma domain, for example, by using already reconstructed data from the same frame. The chroma intra pred block or circuit 102 may perform cross-component prediction, for example, predicting chroma from luma. The operation of the chroma intra pred block or circuit 102 may be performed by a deep neural network such as a convolutional auto-encoder.

- An intra pred block or circuit 103 and inter-pred block or circuit 104. These blocks or circuit perform intra prediction and inter-prediction, respectively. The intra pred block or circuit 103 and the inter-pred block or circuit 104 may perform the prediction on all components, for example, luma and chroma. The operations of the intra pred block or circuit 103 and inter-pred block or circuit 104 may be performed by two or more deep neural networks such as convolutional auto-encoders.

- A probability estimation block or circuit 105 for entropy coding. This block or circuit performs prediction of probability for the next symbol to encode or decode, which is then provided to the entropy coding module 112, such as the arithmetic coding module, to encode or decode the next symbol. The operation of the probability estimation block or circuit 105 may be performed by a neural network.

- A transform and quantization (T/Q) block or circuit 106. These are actually two blocks or circuits. The transform and quantization block or circuit 106 may perform a transform of input data to a different domain, for example, the FFT transform would transform the data to frequency domain. The transform and quantization block or circuit 106 may quantize its input values to a smaller set of possible values. In the decoding loop, there may be inverse quantization block or circuit and inverse transform block or circuit 113. One or both of the transform block or circuit and quantization block or circuit may be replaced by one or two or more neural networks. One or both of the inverse transform block or circuit and inverse quantization block or circuit 113 may be replaced by one or two or more neural networks.

- An in-loop filter block or circuit 107. Operations of the in-loop filter block or circuit 107 is performed in the decoding loop, and it performs filtering on the output of the inverse transform block or circuit, or anyway on the reconstructed data, in order to enhance the reconstructed data with respect to one or more predetermined quality metrics. This filter may affect both the quality of the decoded data and the bitrate of the bitstream output by the encoder. The operation of the in-loop filter block or circuit 107 may be performed by a neural network, such as a convolutional auto-encoder. In examples, the operation of the in-loop filter may be performed by multiple steps or filters, where the one or more steps may be performed by neural networks.

- A postprocessing filter block or circuit 108. The postprocessing filter block or circuit 108 may be performed only at decoder side, as it may not affect the encoding process. The postprocessing filter block or circuit 108 filters the reconstructed data output by the in-loop filter block or circuit 107, in order to enhance the reconstructed data. The postprocessing filter block or circuit 108 may be replaced by a neural network, such as a convolutional auto-encoder.

- A resolution adaptation block or circuit 109: this block or circuit may downsample the input video frames, prior to encoding. Then, in the decoding loop, the reconstructed data may be upsampled, by the upsampling block or circuit 110, to the original resolution. The operation of the resolution adaptation block or circuit 109 block or circuit may be performed by a neural network such as a convolutional auto-encoder.

- An encoder control block or circuit 111. This block or circuit performs optimization of encoder's parameters, such as what transform to use, what quantization parameters (QP) to use, what intra-prediction mode (out of N intra-prediction modes) to use, and the like. The operation of the encoder control block or circuit 111 may be performed by a neural network, such as a classifier convolutional network, or such as a regression convolutional network.

- An ME/MC block or circuit 114 performs motion estimation and/or motion compensation, which are two key operations to be performed when performing inter-frame prediction. ME/MC stands for motion estimation / motion compensation.

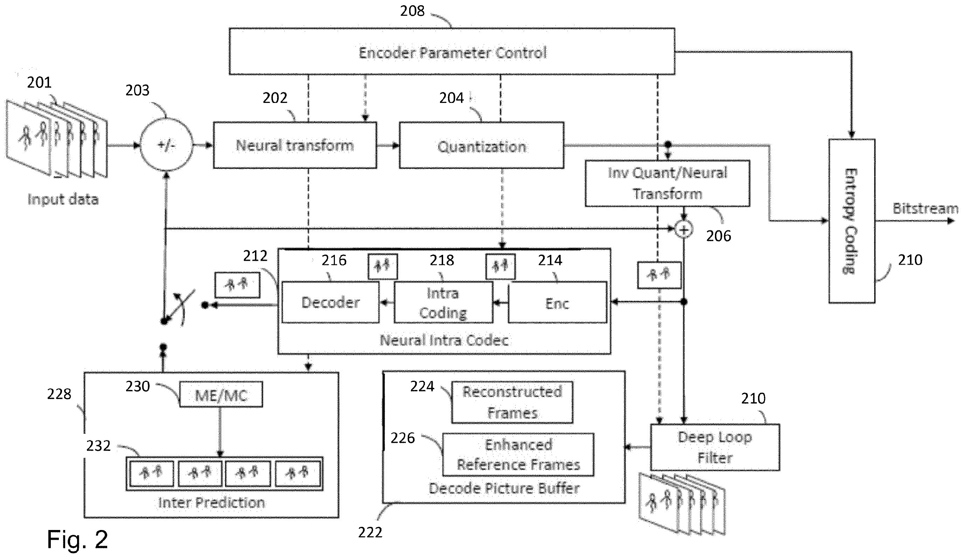

In another approach, commonly referred to as "end-to-end learned compression", NNs are used as the main components of the image/video codecs. In this second approach, there are two main options:
Option 1: re-use the video coding pipeline but replace most or all the components with NNs. Referring to Figure 2, it illustrates an example of modified video coding pipeline based on a neural network, in accordance with an embodiment. An example of neural network may include, but is not limited to, a compressed representation of a neural network. Figure 2 is shown to include following components:

- A neural transform block or circuit 202: this block or circuit transforms the output of a summation/subtraction operation 203 to a new representation of that data, which may have lower entropy and thus be more compressible.
- A quantization block or circuit 204: this block or circuit quantizes an input data 201 to a smaller set of possible values.
- An inverse transform and inverse quantization blocks or circuits 206. These blocks or circuits perform the inverse or approximately inverse operation of the transform and the quantization, respectively.
- An encoder parameter control block or circuit 208. This block or circuit may control and optimize some or all the parameters of the encoding process, such as parameters of one or more of the encoding blocks or circuits.
- An entropy coding block or circuit 210. This block or circuit may perform lossless coding, for example based on entropy. One popular entropy coding technique is arithmetic coding.
- A neural intra-codec block or circuit 212. This block or circuit may be an image compression and decompression block or circuit, which may be used to encode and decode an intra frame. An encoder 214 may be an encoder block or circuit, such as the neural encoder part of an auto-encoder neural network. A decoder 216 may be a decoder block or circuit, such as the neural decoder part of an auto-encoder neural network. An intra-coding block or circuit 218 may be a block or circuit performing some intermediate steps between encoder and decoder, such as quantization, entropy encoding, entropy decoding, and/or inverse quantization.
- A deep loop filter block or circuit 220. This block or circuit performs filtering of reconstructed data, in order to enhance it.
- A decode picture buffer block or circuit 222. This block or circuit is a memory buffer, keeping the decoded frame, for example, reconstructed frames 224 and enhanced reference frames 226 to be used for inter prediction.
- An inter-prediction block or circuit 228. This block or circuit performs inter-frame prediction, for example, predicts from frames, for example, frames 232, which are temporally nearby. An ME/MC 230 performs motion estimation and/or motion compensation, which are two key operations to be performed when performing inter-frame prediction. ME/MC stands for motion estimation / motion compensation.

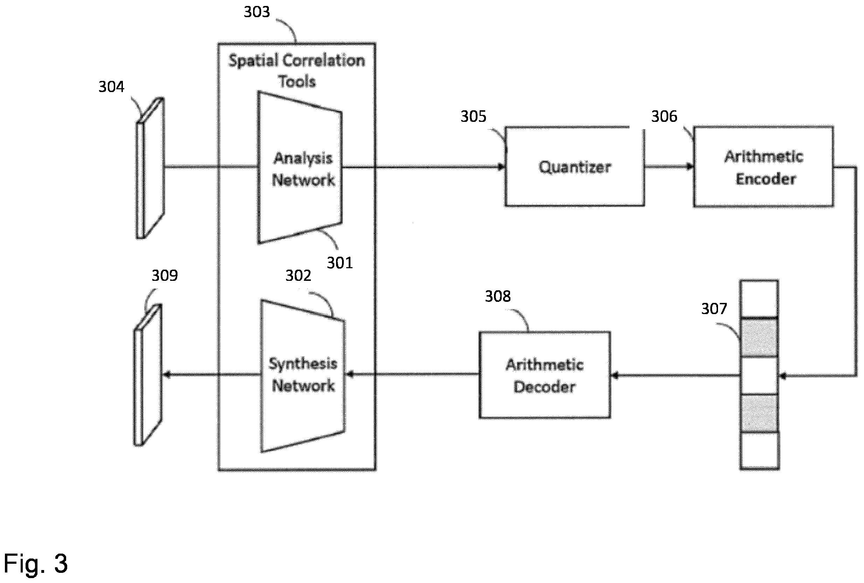

Option 2: re-design the whole pipeline, as follows. An example of option 2 is described in detail in Figure 3:

- Encoder NN: performs a non-linear transform
- Quantization and lossless encoding of the encoder NN's output.
- Lossless decoding and dequantization.
- Decoder NN: performs a non-linear inverse transform.

Figure 3 depicts an encoder and a decoder NNs being parts of a neural auto-encoder architecture, in accordance with an example. In Figure 3, the Analysis Network 301 is an Encoder NN, and the Synthesis Network 302 is the Decoder NN, which may together be referred to as spatial correlation tools 303, or as neural auto-encoder.

In the Option 2, the input data 304 is analyzed by the Encoder NN (Analysis Network 301), which outputs a new representation of that input data. The new representation may be more compressible. This new representation may then be quantized, by a quantizer 305, to a discrete number of values. The quantized data is then lossless encoded, for example by an arithmetic encoder 306, thus obtaining a bitstream 307. The example shown in Figure 3 includes an arithmetic decoder 308 and an arithmetic encoder 306. The arithmetic encoder 306, or the arithmetic decoder 308, or the combination of the arithmetic encoder 306 and arithmetic decoder 308 may be referred to as arithmetic codec in some embodiments. On the decoding side, the bitstream is first lossless decoded, for example, by using the arithmetic codec decoder 308. The lossless decoded data is dequantized and then input to the Decoder NN, Synthesis Network 302. The output is the reconstructed or decoded data 309.

In case of lossy compression, the lossy steps may comprise the Encoder NN and/or the quantization.

In order to train this system, a training objective function (also called "training loss") may be utilized, which may comprise one or more terms, or loss terms, or simply losses. In one example, the training loss comprises a reconstruction loss term and a rate loss term. The reconstruction loss encourages the system to decode data that is similar to the input data, according to some similarity metric. Examples of reconstruction losses are:

- Mean squared error (MSE).
- Multi-scale structural similarity (MS-SSIM)
- Losses derived from the use of a pretrained neural network. For example, error(f1, f2), where f1 and f2 are the features extracted by a pretrained neural network for the input data and the decoded data, respectively, and error() is an error or distance function, such as L1 norm or L2 norm.
- Losses derived from the use of a neural network that is trained simultaneously with the end-to-end learned codec. For example, adversarial loss can be used, which is the loss provided by a discriminator neural network that is trained adversarially with respect to the codec, following the settings proposed in the context of Generative Adversarial Networks (GANs) and their variants.

The rate loss encourages the system to compress the output of the encoding stage, such as the output of the arithmetic encoder. By "compressing", we mean reducing the number of bits output by the encoding stage.

When an entropy-based lossless encoder is used, such as an arithmetic encoder, the rate loss typically encourages the output of the Encoder NN to have low entropy. Example of rate losses are the following:

- A differentiable estimate of the entropy.
- A sparsification loss, i.e., a loss that encourages the output of the Encoder NN or the output of the quantization to have many zeros. Examples are L0 norm, L1 norm, L1 norm divided by L2 norm.
- A cross-entropy loss applied to the output of a probability model, where the probability model may be a NN used to estimate the probability of the next symbol to be encoded by an arithmetic encoder.

One or more of reconstruction losses may be used, and one or more of the rate losses may be used, as a weighted sum. The different loss terms may be weighted using different weights, and these weights determine how the final system performs in terms of rate-distortion loss. For example, if more weight is given to the reconstruction losses with respect to the rate losses, the system may learn to compress less but to reconstruct with higher accuracy (as measured by a metric that correlates with the reconstruction losses). These weights may be considered to be hyperparameters of the training session, and may be set manually by the person designing the training session, or automatically for example by grid search or by using additional neural networks.

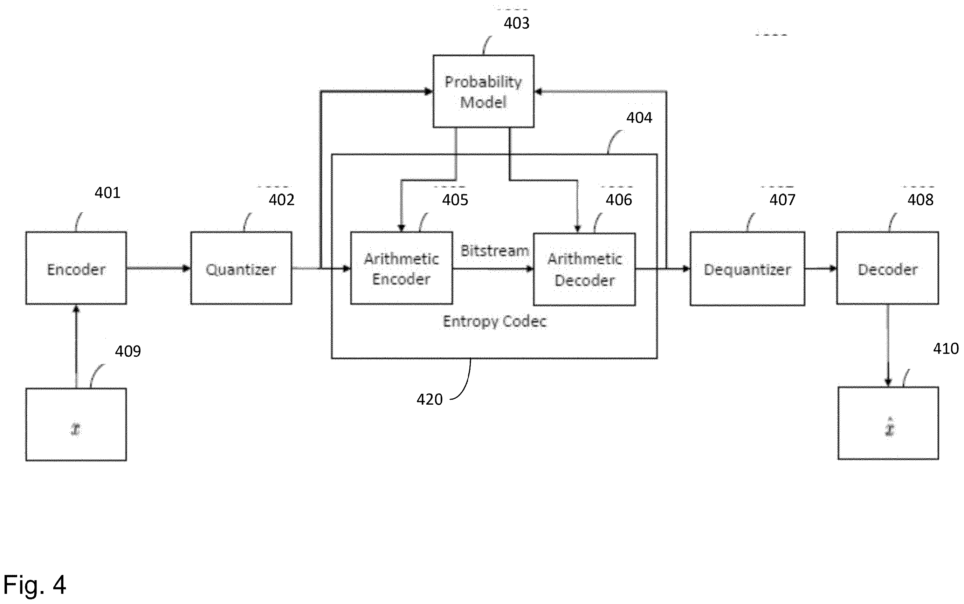

As shown in Figure 4, a neural network-based end-to-end learned video coding system may contain an encoder 401, a quantizer 402, a probability model 403, an entropy codec 420 (for example arithmetic encoder 405 / arithmetic decoder 406), a dequantizer 407, and a decoder 408. The encoder 401 and decoder 408 may be two neural networks, or mainly comprise neural network components. The probability model 403 may also comprise mainly neural network components. Quantizer 402, dequantizer 407 and entropy codec 420 may not be based on neural network components, but they may also comprise neural network components, potentially.

On encoder side, the encoder component 401 takes a video $x$ 409 as input and converts the video from its original signal space into a latent representation that may comprise a more compressible representation of the input. In the case of an input image, the latent representation may be a 3-dimensional tensor, where two dimensions represent the vertical and horizontal spatial dimensions, and the third dimension represent the "channels" which contain information at that specific location. If the input image is a 128x128x3 RGB image (with horizontal size of 128 pixels, vertical size of 128 pixels, and 3 channels for the Red, Green, Blue color components), and if the encoder downsamples the input tensor by 2 and expands the channel dimension to 32 channels, then the latent representation is a tensor of dimensions (or "shape") 64x64x32 (i.e., with horizontal size of 64 elements, vertical size of 64 elements, and 32 channels). Please note that the order of the different dimensions may differ depending on the convention which is used; in some cases, for the input image, the channel dimension may be the first dimension, so for the above example, the shape of the input tensor may be represented as 3x128x128, instead of 128x128x3. In the case of an input video (instead of just an input image), another dimension in the input tensor may be used to represent temporal information.

The quantizer component 402 quantizes the latent representation into discrete values given a predefined set of quantization levels. Probability model 403 and arithmetic codec component 420 work together to perform lossless compression for the quantized latent representation and generate bitstreams to be sent to the decoder side. Given a symbol to be encoded into the bitstream, the probability model 403 estimates the probability distribution of all possible values for that symbol based on a context that is constructed from available information at the current encoding/decoding state, such as the data that has already been encoded/decoded. Then, the arithmetic encoder 405 encodes the input symbols to bitstream using the estimated probability distributions.

On the decoder side, opposite operations are performed. The arithmetic decoder 406 and the probability model 403 first decode symbols from the bitstream to recover the quantized latent representation. Then the dequantizer 407 reconstructs the latent representation in continuous values and pass it to decoder 408 to recover the input video/image. Note that the probability model 403 in this system is shared between the encoding and decoding systems. In practice, this means that a copy of the probability model 403 is used at encoder side, and another exact copy is used at decoder side.

In this system, the encoder 401, probability model 403, and decoder 408 may be based on deep neural networks. The system may be trained in an end-to-end manner by minimizing the following rate-distortion loss function:

$$L = D + \lambda R,$$

where D is the distortion loss term, R is the rate loss term, and $\lambda$ is the weight that controls the balance between the two losses. The distortion loss term may be the mean square error (MSE), structure similarity (SSIM) or other metrics that evaluate the quality of the reconstructed video. Multiple distortion losses may be used and integrated into D, such as a weighted sum of MSE and SSIM. The rate loss term is normally the estimated entropy of the quantized latent representation, which indicates the number of bits necessary to represent the encoded symbols, for example, bits-per-pixel (bpp).

For lossless video/image compression, the system may contain only the probability model 403 and arithmetic encoder/decoder 405, 406. The system loss function contains only the rate loss, since the distortion loss is always zero (i.e., no loss of information).

Numerical stability is a property of a mathematical algorithm that describes the deviation of the system outputs caused by small errors, fluctuation and/or changes to the input data or computing environment. It is a critical property for video coding systems. In this disclosure, the numerical stability issues are focused on the decoding process, where the instability is caused by the differences in the environments and the decoding process. With a numerically stable video coding system, a compressed bitstream shall be decoded correctly (i.e., as expected by the encoder) by decoders running in different environments. There can be two levels of numerical stability for video coding systems:

1) The decoded videos under different environments have the same level of visual quality, which also matches the intended visual quality of the encoding process. It is to be noticed that the decoded videos may differ from each other even though the visual qualities are the same or very close.

2) The decoders generate the same outputs under different environments. At the first level, the performance of a video coding system remains consistent in different environments and the small deviation of the output does not affect the practical usage of the system, especially when the decoded video is watched by a human. However, the system may have problems with some conformance tests when the exact output is expected.

The numerical stability problem for a video coding system may be caused by inaccuracy of floating-point number calculation, limitation of the precision of the floating-point numbers, and/or limited range of the numerical computing environment. The main cause of the problem is related to floating-point arithmetic. Deep neural networks may rely on floating-point number calculation because of the nonlinear functions in the system and the mechanism of backpropagation used in training. Furthermore, they benefit from hardware that supports parallel computing. The implementation of parallel computing also has dramatic impacts on numerical stability.

Neural networks running in different environments, including mathematical libraries, device drivers and hardware platforms, may generate different outputs from the same input. The difference may be caused by various reasons, for example, the configuration of the compiler, the difference in the numeric standards, and/or the hardware architecture.

For a neural network, although the difference of the floating-point number output by an operation is small under different environment, the effect to the video coding systems can be catastrophic due to the complexity of the system, which may amplify the small differences into bigger differences in the final output of the system. In the following, some examples (Case 1 - Case 3) of the problems caused by unstable behaviour when neural networks are used in video coding systems are described:

**Case 1:**

When a neural network is used as the decoder of an end-to-end learned video coding system, or for performing a decoder-side operation within a traditional video coding system such as an in-loop filter or a post-processing filter, the output of the neural network is rounded to discrete values to generate the final output. When the two values output by an operation in the two environments are close to a decision boundary of the rounding operation, they can be rounded to different integers on different environments because of the small variations. For example, let's assume that the values in the two environments are 0.499999 and 0.500001, these values may be then rounded to 0 and 1, respectively, although the difference between the two numbers before rounding is very small. This causes the pixel values of the output, the decoded image or a video frame to differ by 1 on the two different environments. The systems having this problem may only achieve the first level of numerical stability.

**Case 2:**

A probability model is a component that runs on both the encoder and decoder side of a video coding system. The probability model may be used for providing an estimate of a probability for a symbol to be encoded or decoded by a lossless encoder or decoder, such as an entropy encoder or entropy decoder. If the probability model behaves differently at encoding and decoding stages, for example, giving different probability distribution functions when running on different hardware and/or software environments, the encoded bitstream may not be correctly decoded. This is a major issue with entropy decoding, since an error at one point can ruin the most of the decoding process. In this case, the system may output corrupted images or video frames.

**Case 3:**

In a video coding system, the encoder and decoder use the same set of reference frames or reference blocks (a block is a patch or portion of an image or video frame, such as the "Coding Tree Unit" or "CTU" concept in video codecs) as the context information when encoding/decoding a certain frame or block. For example, the decoder may perform inter-frame prediction, where a frame is predicted from one or more previously reconstructed frames. In another example, the decoder may perform intra-frame prediction, where one block (CTU) may be predicted from one or more previously reconstructed blocks (CTUs). When the encoder and the decoder run on different environments, one or more reference frames, or one or more reference blocks, may be different because of the reasons shown in case 1 and/or case 2. The error may propagate through the decoding process and result in a corrupted reconstructed block or a corrupted set of blocks or a corrupted frame or even a corrupted sequence of video frames.

Video codecs, such as HEVC/H.265 and WC/H.266 avoid the unstable behaviour of the decoder or probability model by prohibiting floating-point arithmetic at the decoder side. So, only integer arithmetic is allowed in the decoder or probability model.

Neural network-based video coding systems are still at an early developing phase. The numerical stability issues of the decoder and the probability model have not been well studied. The most relevant study is about integer or discrete neural networks, which aims at fast inference, small model size and cheap hardware platform. The full integer neural network, where both model parameters and activation maps are in integer format can solve the problem caused by various difficulties related to floating-point number arithmetic. However, the neural networks always contain nonlinear functions, for example, sigmoid, hyperbolic tangent, and softmax function, which makes the integer neural network difficult to train. The integer neural networks may not achieve the same accuracy as floating-point neural networks. For example, when used for classification tasks, the integer neural networks have a few percent lower accuracy compared to floating-point neural networks.

The present embodiments propose multiple solutions for the numerical stability problems of neural network -based video coding system. Either one of the solutions or the combination of two or more of the proposed solutions can be applied to achieve a numerical stable video coding system that contains floating-point neural networks.

It is to be understood that the proposed solutions may be applied to other use cases than learned video coding systems. In general, the proposed solutions may be applied to any use case where a neural network is required to perform in a substantially same manner independently of the environment (such as hardware, drivers, software libraries) on which it is run or executed or used.

For simplicity, in the rest of the disclosure, two example scenarios are considered, where floating-point neural networks may generate stability issues for a video coding system. The proposed solutions can be used in other scenarios, for example when neural networks are used as in-loop filter, in a similar manner.

**Scenario 1:** Floating-point neural networks are used as the decoder in an end-to-end learned video coding system or the post-filter of a traditional video coding system.

**Scenario 2:** Floating-point neural networks are used as the probability model in an end-to-end learned video coding system or in a traditional video coding system.

According to an embodiment, an error detection code is added to the output of the system for scenario 1 or to the output of the entropy decoder for scenario 2.

According to another embodiment, the latent representation (i.e., the output of the encoder neural network in an end-to-end learned image or video codec system) is tweaked so that the neural networks do not generate floating-point outputs that are close to decision boundaries.

According to yet another embodiment, the encoder can transfer adjustment parameters to the decoder. The decoder may use the parameters to adjust the outputs to have values away from decision boundaries.

According to yet another embodiment, the neural networks are trained with certain loss terms to avoid output values close to decision boundaries.

According to yet another embodiment, the neural networks use mixed data types in the probability model and the decoder at the inference stage. The operations where numerical stability may not be guaranteed when using floating-point data type, are performed using integer data type, while the other operations are performed using floating-point data type.

The previous embodiments can be applied alone or combined with other embodiments to solve the numerical unstable problem.

The previous embodiments are discussed in more detailed manner next.

A mathematical calculation may yield different outputs in different environments, when floating-point arithmetic is involved because of one or more reasons, including the precision limitation, representations format, calculation procedure, the implementation to support parallel computing, and the like. In some of the embodiments herein, the "mathematical output" of an operation is defined as the result when the calculation is performed by a system with infinite precision. In some of the embodiments herein, the "precision of a system" is defined as the biggest deviation from the mathematical output given the input from the set of all possible inputs. For neural networks in a video coding system, the precision of the decoder, either for scenario 1 or scenario 2, is a small floating-point value, for example, 1E-7. It is also reasonable to require that the precision of the decoder must be higher than a predefined precision level for a decoding environment.

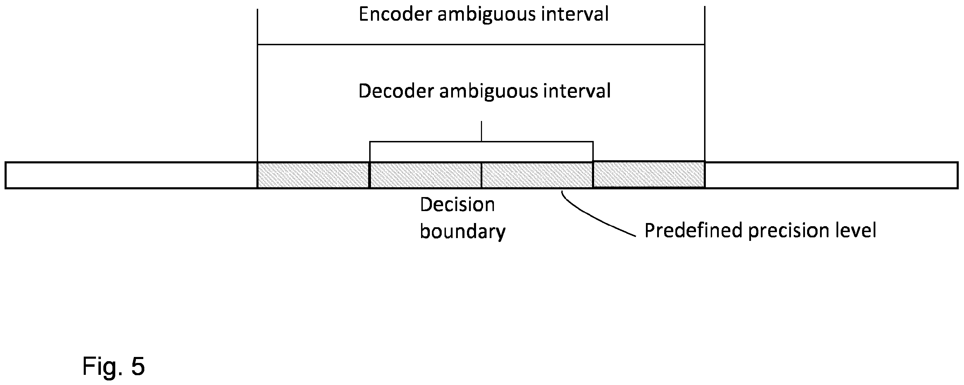

Given the predefined precision level, the decoder may determine an ambiguous interval as the range of the values around a decision boundary within a distance equal to the predefined precision level. When an encoder outputs a data point with a value within the decoder ambiguous interval, the corresponding mathematical output of that data point may be on the other side of the decision boundary and the rounding operation will generate a different output. Such a situation may occur especially when the decoder's computing environment is different from the encoder's environment. The encoder ambiguous interval is defined twice as large as the decoder ambiguous interval. The encoder ambiguous interval represents the set of values at the encoder side which may be mapped to one of the values in the decoder ambiguous interval at the decoder side. When the encoder outputs a value within the encoder ambiguous interval, the decoder may output a value within the decoder ambiguous interval. The relations about the decision boundary, predefined precision level, encoder ambiguous interval and decoder ambiguous interval are illustrated in Figure 5.

The encoder ambiguous interval and decoder ambiguous interval may be predefined. However, the encoder can also determine the decoder ambiguous interval according to the input data and send the interval value to the decoder. According to another embodiment, the encoder can determine a parametric function to calculate the decoder ambiguous interval and send the corresponding parameters to the decoder.

**Error detection code**

According to this embodiment, the encoder is configured to add error detection codes to the output of the system. For scenario 1, the error detection codes are added to the output of the system, i.e., the reconstructed frame. For scenario 2, the error detection codes are added to the output of the entropy decoder, i.e., the estimated probability distribution function. The error detection codes are sent from encoder to decoder in a compressed or uncompressed format.

The error detection codes are generated for the discrete values. For scenario 1, the output of the decoder neural network is quantized to generate the reconstructed frames. For scenario 2, the estimated probability function is quantized to certain precision before passed to the arithmetic codec.

During the encoding and decoding process, for each ambiguous data point (i.e., the data point that falls into the encoder ambiguous interval at the encoder side and the data point that falls into the decoder ambiguous interval at the decoder side), the encoder and decoder can expand the process with the two possible outputs. The encoding/decoding procedure is executed in a tree structure where each ambiguous data point splits the procedure. The leaf nodes of the tree are the possible outputs of the decoder/encoder. It is to be noticed that the encoder ambiguous interval is twice as large as the decoder ambiguous interval, thus the number of leaf nodes of the encoding tree is higher than the number of leaf nodes of the decoding tree.

Given all possible outcomes from the decoder, the encoder calculates an error detection code that can determine the correct output among all the possibilities. The error detection code together with the length of it are included in the bitstream and sent to the decoder. At the decoder side, the decoder uses the received error detection code to determine the true output from all possible outcomes, i.e., the same output value as on the encoder side.

A method according to an embodiment for deriving error detection code can comprise the following steps:

- given all possible outcomes, where one of the outcomes is the correct outcome, generating a parity sequence by the encoder, wherein the parity sequence is a binary sequence indicating the parity (even or odd) of each number, for each outcome;
- calculating the checksum (e.g., CRC32, md5, SHA-1 hash) of each parity sequence by the encoder;
- converting the checksum numbers into binary format by the encoder;
- given the checksum number for each outcome, determining, by the encoder, the minimum length of bits that distinguishes the true outcome from the rest of the other outcomes and generating the identity code from it;
- generating the error detection code by concatenating, by the encoder, the length of the identity code and the identity code together.

According to an embodiment, the length of the identity code has a fixed length. According to another embodiment, the length of the identity code has variable length and is encoded, for example using Golomb or unary encoding method.

Table 1 shows an example of error detection code generation. The first row is the correct outcome. It is to be noticed that the first 3 bits of the error detection code are unary encoded identity code length.

| Possible outcomes | Parity sequence | Binary checksum | Identity code | Error detection code |
|---|---|---|---|---|
| 12,3,5,0,4 | 0,1,1,0,0 | 100101111 | 100 | 110 100 |
| 12,4,5,0,4 | 0,0,1,0,0 | 011010101 | | |
| 12,3,5,0,5 | 0,1,1,0,1 | 101000100 | | |
| 12,4,5,0,5 | 0,0,1,0,1 | 001010010 | | |
| | | | | |

It is to be noticed that the possible outcomes are the decoded frames for scenario 1, and the entropy coded latent representation for scenario 2. According to an embodiment, an output tensor can be split into partitions and error detection codes are generated for each partition separately. The partition of the output tensor can be sent from the encoder to the decoder.

**Latent tensor tweaking**

In this embodiment, an end-to-end learned image or video codec system is considered. The encoder tweaks the latent tensor so that the output from the decoder (scenario 1) or the output from the probability model (scenario 2) does not fall into the decoder ambiguous interval. Here, latent tensor, or latent representation, indicates the output of the encoder before lossless coding, either before the quantization step or after the quantization step.

The tweaking can be accomplished by finetuning the latent representation with an extra loss term in training. "Finetuning the latent representation" refers to performing one or more training iterations, where at each training iteration a loss function is minimized with respect to one or more elements of the latent representation. The minimization may be performed by computing one or more gradients of the loss function with respect to one or more elements of the latent representation, where the gradient may be computed for example by back-propagation. The computed gradients may then be used by an optimizer routine, such as Stochastic Gradient Descent or Adam, for updating the values of one or more elements of the latent representation. For example, the system may be finetuned by minimizing the following loss function with respect to the latent representation

$$L = D + \lambda R + \beta F \qquad \text{Equation (2)}$$

where D is a distortion term, such as Mean Squared Error (MSE), R is a rate term, such as an estimate of the bitrate, $\lambda$ and $\beta$ may be predetermined weighting coefficients, and F is the loss term that penalizes the outputs that fall into the decoder ambiguous interval. One example of such loss term is defined as

$$F = max(d - abs(y - round(y) - 0.5), 0) \qquad \text{Equation (3)}$$

where d is the width of the decoder ambiguous interval, y is the output of the neural network, *abs* represents the absolute value function. During the finetuning, the optimization may be stopped whenever no data points fall into the ambiguous interval, or when another stopping criterion is met.

According to an additional embodiment, the finetuning is performed with respect to one or more decoder-side neural networks' parameters.

According to an additional embodiment, the finetuning is performed with respect to one or more elements of the latent representation, and one or more decoder-side neural networks' parameters.

In those cases, where the finetuning is performed with respect to at least one or more decoder side neural networks' parameters, the encoder-side may send the one or more finetuned decoder-side neural networks' parameters, or may send the difference between the one or more finetuned decoder-side neural networks' parameters and the corresponding decoder-side neural networks' parameters before being finetuned. The finetuned parameters or the difference between finetuned parameters and non-finetuned parameters may be encoded by using lossy and/or lossless compression and then sent to the decoder.

**Output adjustment**

In this embodiment, the encoder calculates adjustment parameters and sends them to the decoder. According to an example, the output adjustment parameters are floating-point numbers that define the offset of the adjustment. The decoder adjusts the output of the neural network with the received adjustment offset and performs rounding operations after the adjustment. The adjustment value is determined by the encoder so that no data points fall into the decoder ambiguous interval after the adjustment.

According to another example, the encoder determines an adjustment function defined by a set of parameters and transfers the parameters to the decoder. The decoder adjusts the output by the function specified by the encoder.

According to yet another example, the adjustment parameters are compressed and encoded.

**Ambiguous avoidance training**

In this embodiment, the video coding system, or the part with neural networks, is trained with a loss function with loss terms that penalize the output values that fall into the decoder ambiguous interval. Examples of the loss function and the loss terms are shown in Equations (2) and (3).

**Mixed data types**

In this embodiment, the operations where numerical stability is not guaranteed are performed using integer data type, while other operations are performed using floating-point data type. The video coding system is trained in floating-point data type to achieve the best performance. At the encoding and decoding stage, one or more operations in the probability model and/or decoder are converted into one or more integer operations to achieve numerical stability. The one or more operations to be performed in integer data type include operations like convolution, matrix multiplication, average pooling, projection by a fully connected layer.

Next, 2D convolution is used as an example to illustrate the embodiment. The same principle applies to other operations in the same manner.

A convolution involves an input tensor and a convolutional kernel, referred to as weight tensor. The one or more values of the weight tensor are derived from a training procedure by optimizing a predefined loss function using a training dataset. The input tensor and the weight tensor are both in floating-point data type after the training. At the inference stage, for example, encoding and decoding an input media data, the floating-point values of the input tensor and the weight tensor are first scaled by scaling factor $\alpha$ and $\beta$, respectively. Then, the scaled floating-point values are quantized and converted into integer data type. Then, the convolution operation is performed with the integer input tensor and the integer weight tensor. Since the integer arithmetic generates deterministic results regardless of the implementation variation on different environments, numerical stability is guaranteed. After the convolution operation, the one or more results are converted back to floating-point values and scaled by scaling factor $\frac{1}{\alpha \cdot \beta}$ to generate the final convolution results.

Let S be the number of significant precision bits of the floating-point system. For example, S=23 for 32bits floating-point number according to the IEEE 754 standard. The precision range of integer values that can be precisely represented by the system is $[-2^{S+1}, 2^{S+1}]$. The scaling factors $\alpha$ and $\beta$ are chosen so that the convolution operation does not cause overflow, i.e. the final results or the intermediate results contain values that are out of the precision range.

Let y be an element in the result tensor of a 2D convolution operation with kernel size k. *y* is calculated by

$$y = \sum_{i}^{k^2 \cdot C} x_i w_i$$ , where $x_i$ is an element in the input tensor, $w_i$ is the corresponding element in the weight tensor, and C is the number of channels of the input tensor. The scaling factors are determined by inequality

$$\alpha \cdot \beta \cdot k^2 \cdot C \cdot m_i \cdot m_k \leq 2^{S+1}$$

where $m_i$ is the maximum of the absolute value of the input tensor and $m_k$ is the maximum of the absolute value of the weight tensor.

According to an embodiment, parameter $\alpha$ and $\beta$ are calculated by equation

$$\alpha = \beta = \sqrt{\frac{2^{S+1}}{k^2 \cdot C \cdot m_i \cdot m_k}}$$

In this embodiment, the input tensor and the weight tensor are scaled by the same scaling factor.

According to another embodiment, parameter $\alpha$ and $\beta$ are selected by

$$\alpha = \frac{\sqrt{\dfrac{2^{S+1}}{k^2 \cdot C}}}{m_i}$$

$$\beta = \frac{\sqrt{\dfrac{2^{S+1}}{k^2 \cdot C}}}{m_k}$$

In this embodiment, the input tensor and the weight tensor are scaled by different scaling factors. The precision level for the input tensor and the weight tensor is similar.

According to yet another embodiment, the number of significant precision bits is transferred to the decoder to calculate the scaling factors.

According to yet another embodiment, the encoder determines the scaling factors $\alpha$ and $\beta$ at the encoding stage. Then the scaling factors can be quantized, compressed and included into the bitstream. The decoder uses the received scaling factors to scale the input variable and weight before applying the convolution operation.

According to yet another embodiment, the scaling factors are determined for each convolution operation in the probability model and decoder.

According to yet another embodiment, the scaling factors are determined for groups of convolution operations. For example, the convolution operations can be grouped according to their positions in the deep CNN.

If a bias is applied after the convolution, the bias can be involved in the convolution operation to achieve a faster computation. In this case, the inequality to determine the scaling factors becomes

$$\alpha \cdot \beta \cdot k^2 \cdot C \cdot m_i \cdot m_k \leq 2^S$$

The bias is first scaled by scaling factor $\alpha \cdot \beta$, then rounded and converted into integer values.

According to one embodiment, when bias is used in a convolution, the scaling factors $\alpha$ and $\beta$ are calculated by

$$\alpha = \beta = \sqrt{\frac{2^S}{k^2 \cdot C \cdot m_i \cdot m_k}}$$

According to another embodiment, when bias is used in a convolution, the scaling factors $\alpha$ and $\beta$ are calculated by

$$\alpha = \frac{\sqrt{\dfrac{2^S}{k^2 \cdot C}}}{m_i}$$

$$\beta = \frac{\sqrt{\dfrac{2^S}{k^2 \cdot C}}}{m_k}$$

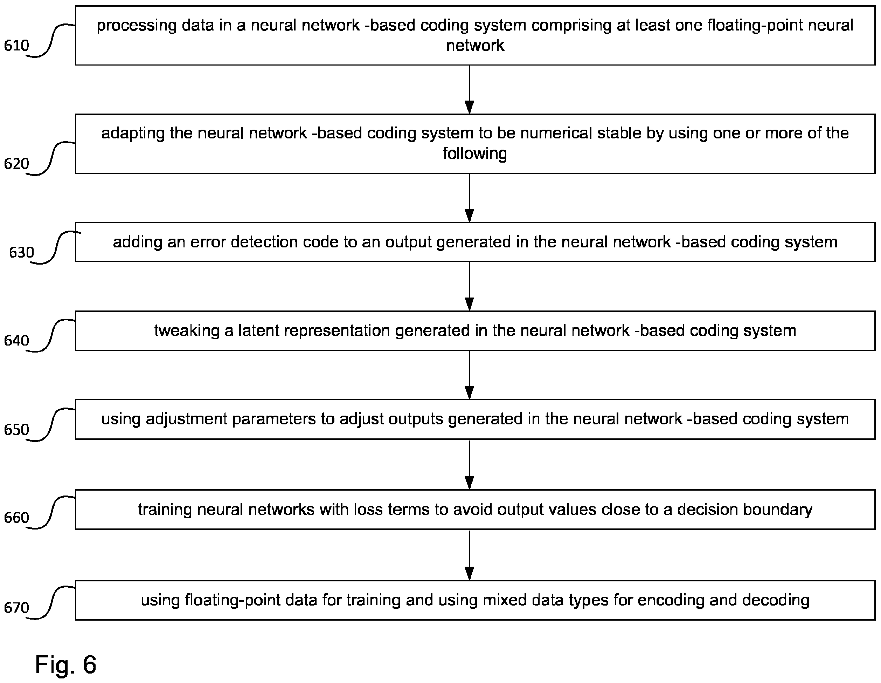

The method according to an embodiment is shown in Figure 6. The method generally comprises processing (610) data in a neural network -based coding system comprising at least one floating-point neural network; and adapting (620) the neural network -based coding system to be numerical stable by using one or more of the following: adding (630) an error detection code to an output generated in the neural network -based coding system; tweaking (640) a latent representation generated in the neural network -based coding system; using (650) adjustment parameters to adjust outputs generated in the neural network -based coding system; training (660) neural networks with loss terms to avoid output values close to a decision boundary; and using (670) floating-point data for training and using mixed data types for encoding and decoding. Each of the steps can be implemented by a respective module of a computer system.

An apparatus according to an embodiment comprises means for processing data in a neural network -based coding system comprising at least one floating-point neural network; means for adapting the neural network-based coding system to be numerical stable by using one or more of the following: adding an error detection code to an output generated in the neural network -based coding system; tweaking a latent representation generated in the neural network -based coding system; using adjustment parameters to adjust outputs generated in the neural network -based coding system; training neural networks with loss terms to avoid output values close to a decision boundary; and using floating-point data for training and using mixed data types for encoding and decoding. The means comprises at least one processor, and a memory including a computer program code, wherein the processor may further comprise processor circuitry. The memory and the computer program code are configured to, with the at least one processor, cause the apparatus to perform the method of Figure 6 according to various embodiments.

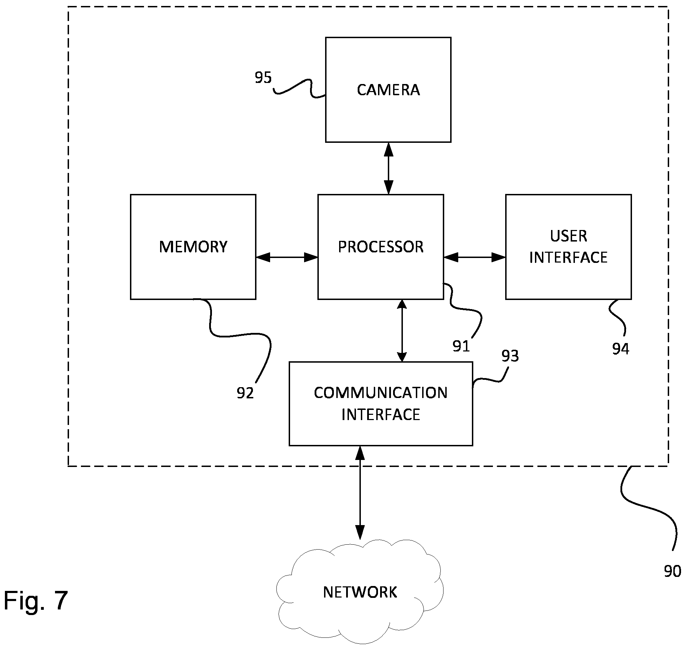

Figure 7 illustrates an example of an apparatus. The apparatus is a user equipment for the purposes of the present embodiments. The apparatus 90 comprises a main processing unit 91, a memory 92, a user interface 94, a communication interface 93. The apparatus according to an embodiment, shown in Figure 10, may also comprise a camera module 95. Alternatively, the apparatus may be configured to receive image and/or video data from an external camera device over a communication network. The memory 92 stores data including computer program code in the apparatus 90. The computer program code is configured to implement the method according various embodiments by means of various computer modules. The camera module 95 or the communication interface 93 receives data, in the form of images or video stream, to be processed by the processor 91. The communication interface 93 forwards processed data, i.e. the image file, for example to a display of another device, such a virtual reality headset. When the apparatus 90 is a video source comprising the camera module 95, user inputs may be received from the user interface.

The various embodiments can be implemented with the help of computer program code that resides in a memory and causes the relevant apparatuses to carry out the method. For example, a device may comprise circuitry and electronics for handling, receiving and transmitting data, computer program code in a memory, and a processor that, when running the computer program code, causes the device to carry out the features of an embodiment. Yet further, a network device like a server may comprise circuitry and electronics for handling, receiving and transmitting data, computer program code in a memory, and a processor that, when running the computer program code, causes the network device to carry out the features of various embodiments.

If desired, the different functions discussed herein may be performed in a different order and/or concurrently with other. Furthermore, if desired, one or more of the above-described functions and embodiments may be optional or may be combined.

Although various aspects of the embodiments are set out in the independent claims, other aspects comprise other combinations of features from the described embodiments and/or the dependent claims with the features of the independent claims, and not solely the combinations explicitly set out in the claims.

It is also noted herein that while the above describes example embodiments, these descriptions should not be viewed in a limiting sense. Rather, there are several variations and modifications, which may be made without departing from the scope of the present disclosure as, defined in the appended claims.

## Claims

1. An apparatus comprising:

   means for processing data in a neural network -based coding system comprising at least one floating-point neural network; and
   means for adapting the neural network-based coding system to be numerical stable by using one or more of the following:

   adding an error detection code to an output generated in the neural network -based coding system;
   tweaking a latent representation generated in the neural network -based coding system;
   using adjustment parameters to adjust outputs generated in the neural network -based coding system;
   training neural networks with loss terms to avoid output values close to a decision boundary; and
   using floating-point data for training and using mixed data types for encoding and decoding.

**2.** The apparatus according to claim 1, wherein the neural network -based coding system comprises:

means for encoding input data comprising data points into a compressed representation;
means for estimating probability distribution of all possible values for a data point;
means for encoding the data points to a bitstream using the estimated probability distributions; and
means for decoding the data points from the bitstream to recover the compressed representation.

**3.** The apparatus according to claim 1 or 2, wherein the neural network -based coding system comprises:

means for determining an ambiguous interval as a range of values around a precise output value being a decision boundary; and
means for determining when a data point falls into an ambiguous interval, and
means for defining two possible output values for such data point.

**4.** The apparatus according to any of the claims 1 to 3, further comprising:

means for deriving an error detection code based on all possible output values;
means for determining the correct output values among all the possibilities by means of the error detection code; and
means for sending the error detection codes from an encoder to a decoder in compressed or uncompressed format.

**5.** The apparatus according to claim 4, wherein the means for deriving the error detection code comprises:

means for generating a parity sequence for each output value of all possible output values;
means for determining a checksum of each parity sequence;
means for converting the checksums into a binary format;
means for determining minimum length of bits distinguishing a correct output value from all output values and generating an identity code based on the distinguishing bits; and
means for generating an error detection code by concatenating the length of identity code and the identity code together.

**6.** The apparatus according to any of the preceding claims 1 to 5, wherein the means for training the apparatus with floating-point data type and for encoding and decoding data with mixed data type in operations relating to encoding and/or decoding, comprises:

means for determining one or more scaling factors based on a predefined significant precision bits;
means for scaling the floating-point data used for mathematical operations by the one or more scaling factors
means for converting the scaled data into integer data type;
means for applying the mathematical operation to the converted data;
means for converting the output of the mathematical operations into floating-point data type; and
means for applying the one or more scaling factors to the output of the mathematical operations.

**7.** The apparatus according to claim 6, wherein determining one or more scaling factors, comprises:

means for transferring the number of significant bits from the encoder to the decoder,
means for determining the one or more scaling factors at the encoder and transferring the one or more scaling factors to the decoder; and
means for determining different scaling factors for the components in the neural network-based coding system.

**8.** A method, comprising:

processing data in a neural network -based coding system comprising at least one floating-point neural network; and
adapting the neural network -based coding system to be numerical stable by using one or more of the following:

adding an error detection code to an output generated in the neural network -based coding system;
tweaking a latent representation generated in the neural network -based coding system;

using adjustment parameters to adjust outputs generated in the neural network -based coding system;
training neural networks with loss terms to avoid output values close to a decision boundary; and
using floating-point data for training and using mixed data types for encoding and decoding.

9. The method according to claim 8, wherein the method further comprises:

encoding input data comprising data points into a compressed representation; estimating probability distribution of all possible values for a data point;
encoding the data points to a bitstream using the estimated probability distributions; and
decoding the data points from the bitstream to recover the compressed representation.

10. The method according to claim 8 or 9, further comprising:

determining an ambiguous interval as a range of values around a precise output value being a decision boundary; and
determining when a data point falls into an ambiguous interval, and defining two possible output values for such data point.

11. The method according to any of the claims 8 to 10, further comprising:

deriving an error detection code based on all possible output values;
determining the correct output values among all the possibilities by means of the error detection code; and
sending the error detection codes from an encoder to a decoder in compressed or uncompressed format.

12. The method according to claim 11, wherein deriving the error detection code comprises:

generating a parity sequence for each output value of all possible output values;
determining a checksum of each parity sequence;
converting the checksums into a binary format;
determining minimum length of bits distinguishing a correct output value from all output values and generating an identity code based on the distinguishing bits; and
generating an error detection code by concatenating the length of identity code and the identity code together.

13. The method according to any of the preceding claims 8 to 12, wherein training with floating-point data type and for encoding and decoding data with mixed data type in operations relating to encoding and/or decoding comprises:

determining one or more scaling factors based on a predefined significant precision bits;
scaling the floating-point data used for mathematical operations by the one or more scaling factors
converting the scaled data into integer data type;
applying the mathematical operation to the converted data;
converting the output of the mathematical operations into floating-point data type; and
applying the one or more scaling factors to the output of the mathematical operations.

14. The method according to claim 13, wherein determining one or more scaling factors, comprises:

transferring the number of significant bits from the encoder to the decoder,
determining the one or more scaling factors at the encoder and transferring the one or more scaling factors to the decoder; and
determining different scaling factors for the components in the neural network-based coding system.

Fig. 1

Fig. 2

Fig. 3

Fig. 4

Encoder ambiguous interval

Decoder ambiguous interval

Decision
boundary

Predefined precision level

Fig. 5

610 — processing data in a neural network -based coding system comprising at least one floating-point neural network

620 — adapting the neural network -based coding system to be numerical stable by using one or more of the following

630 — adding an error detection code to an output generated in the neural network -based coding system

640 — tweaking a latent representation generated in the neural network -based coding system

650 — using adjustment parameters to adjust outputs generated in the neural network -based coding system

660 — training neural networks with loss terms to avoid output values close to a decision boundary

670 — using floating-point data for training and using mixed data types for encoding and decoding

Fig. 6

Fig. 7